# FASCICULE DE BREVET EUROPEEN

(11) **EP 3 614 439 B1**
(45) Date de publication et mention de la délivrance du brevet: **01.09.2021**
(21) Numéro de dépôt: 19192318.4
(22) Date de dépôt: 19.08.2019
(51) Int. Cl.: H01L 27/32, H01L 51/52

(54) **PIXEL D'UN MICRO-ECRAN A DIODES ELECTROLUMINESCENTES ORGANIQUES**
PIXEL EINES MIKROBILDSCHIRMS MIT ORGANISCHEN ELEKTROLUMINESZENZDIODEN
PIXEL OF A MICRO-SCREEN WITH ORGANIC LIGHT-EMITTING DIODES

(30) Priorité: 21.08.2018 FR 1857558
(43) Date de publication de la demande: 26.02.2020
(73) Titulaire: Commissariat à l'Energie Atomique et aux Energies Alternatives, 75015 Paris (FR)
(72) Inventeur: MOLLARD, Laurent, 38054 GRENOBLE Cedex 09 (FR); MAINDRON, Tony, 38054 GRENOBLE Cedex 09 (FR); TOURNAIRE, Myriam, 38054 GRENOBLE Cedex 09 (FR)
(74) Mandataire: INNOV-GROUP

(56) Documents cités:
- US-A1- 2014 295 597
- US-A1- 2017 154 932

## Description

### Domaine technique

L'invention se rapporte au domaine technique des micro-écrans à diodes électroluminescentes organiques.

L'invention trouve notamment son application dans la fabrication de lunettes et casques à réalité virtuelle ou augmentée, de viseurs d'appareil photo, d'afficheurs tête haute, de pico-projecteurs etc.

### Etat de la technique antérieure

Un pixel d'un micro-écran à diodes électroluminescentes organiques connu de l'état de la technique, notamment du document US 8,956,898 B2, comporte successivement :
- un substrat ;
- un réflecteur, réfléchissant dans le domaine visible, et formé sur le substrat ;
- une couche d'espacement, formée sur le réflecteur ;
- une première électrode, transparente dans le domaine visible, et formée sur la couche d'espacement ;
- un empilement de couches électroluminescentes organiques, configuré pour émettre une lumière blanche, et formé sur la première électrode,
- une seconde électrode, semi-transparente dans le domaine visible, et formée sur l'empilement ; la seconde électrode et le réflecteur formant un résonateur optique ;
   la couche d'espacement possédant des première, deuxième, et troisième portions présentant des épaisseurs adaptées de sorte que le résonateur optique autorise respectivement la transmission de lumières rouge, verte et bleue issues de la lumière blanche émise par l'empilement, de manière à définir respectivement des sous-pixels rouge, vert et bleu.

Un tel pixel de l'état de la technique permet, grâce au réflecteur et à la couche d'espacement agencés sous la première électrode transparente, de déposer aisément l'empilement de couches électroluminescentes organiques sur la première électrode qui forme une surface plane, ce qui n'est pas possible pour d'autres architectures telles que celle décrite dans le document EP 1 672 962 A1, où l'empilement est formé sur la couche d'espacement qui est non-plane (trois portions d'épaisseurs différentes).

En outre, un tel pixel de l'état de la technique permet d'envisager de s'affranchir de filtres colorés grâce au résonateur optique de type Fabry-Pérot formant un filtre interférentiel. La gamme de longueurs d'onde filtrées est déterminée par les épaisseurs des première, deuxième et troisième portions de la couche d'espacement permettant d'ajuster l'épaisseur de la cavité optique (délimitée par le réflecteur et la seconde électrode) de sorte que le résonateur optique autorise respectivement la transmission de lumières rouge, verte et bleue issue de la lumière blanche émise par l'empilement de couches électroluminescentes organiques.

Toutefois, un tel pixel de l'état de la technique n'est pas entièrement satisfaisant dans la mesure où la commande électronique des sous-pixels rouge, vert et bleu est susceptible de conduire à des phénomènes de diaphonie (« *crosstalk* » en langue anglaise) entre des sous-pixels adjacents.

### Exposé de l'invention

L'invention vise à remédier en tout ou partie aux inconvénients précités. A cet effet, l'invention a pour objet un pixel d'un micro-écran à diodes électroluminescentes organiques et son procédé de fabrication tels que définis dans les revendications annexées, le pixel comportant successivement :
- un substrat ;
- un réflecteur, réfléchissant dans le domaine visible, et formé sur le substrat ;
- une couche d'espacement, formée sur le réflecteur ;
- une première électrode, transparente dans le domaine visible, et formée sur la couche d'espacement ;
- un empilement de couches électroluminescentes organiques, configuré pour émettre une lumière blanche, et formé sur la première électrode,
- une seconde électrode, semi-transparente dans le domaine visible, et formée sur l'empilement ; la seconde électrode et le réflecteur formant un résonateur optique ;
la couche d'espacement possédant des première, deuxième, et troisième portions présentant des épaisseurs adaptées de sorte que le résonateur optique autorise respectivement la transmission de lumières rouge, verte et bleue issues de la lumière blanche émise par l'empilement, de manière à définir respectivement des sous-pixels rouge, vert et bleu ;
remarquable en ce que les première et deuxième portions de la couche d'espacement comportent chacune des bords latéraux recouverts d'un matériau réfléchissant dans le domaine visible.

Ainsi, un tel pixel selon l'invention permet de réduire significativement les effets de diaphonie entre les sous-pixels rouge et vert grâce aux bords latéraux réfléchissants des première et deuxième portions de la couche d'espacement qui améliorent le confinement des rayons lumineux réfléchis dans la cavité optique.

### Définitions

- Par «micro-écran», on entend un écran dont chaque pixel présente une surface inférieure ou égale à 30 µm par 30 µm.
- Par « substrat », on entend un support physique autoporté, réalisé dans un matériau de base permettant l'intégration d'un dispositif électronique ou d'un composant électronique. Un substrat est classiquement une tranche (« *wafer* » en langue anglaise) découpée dans un lingot monocristallin de matériau semi-conducteur.
- Par « domaine visible », on entend un spectre électromagnétique compris entre 380 nm et 780 nm.
- Par « réfléchissant », on entend que l'élément correspondant (i.e. le réflecteur ou le matériau recouvrant les bords latéraux) possède un coefficient de réflexion en intensité supérieur ou égal à 70%, de préférence supérieur ou égal à 80%, plus préférentiellement supérieur ou égal à 85%, encore plus préférentiellement supérieur ou égal à 90%, moyenné sur le domaine visible.
- Par « semi-transparente », on entend que la seconde électrode possède un coefficient de transmission en intensité strictement inférieur à 80%, de préférence strictement inférieur à 70%, plus préférentiellement strictement inférieur à 60%, moyenné sur le domaine visible.
- Par « transparente », on entend que la première électrode possède un coefficient de transmission en intensité supérieur ou égal à 70%, de préférence supérieur ou égal à 80%, plus préférentiellement supérieur ou égal à 85%, encore plus préférentiellement supérieur ou égal à 90%, moyenné sur le domaine visible.
- Par « épaisseur », on entend la dimension suivant la normale à la surface du pixel ou du sous-pixel.
- Par « bords latéraux », on entend les bords longitudinaux s'étendant suivant une direction perpendiculaire à la normale au substrat (i.e. la normale à la surface du pixel ou du sous-pixel).

Le pixel selon l'invention peut comporter une ou plusieurs des caractéristiques suivantes.

Selon une caractéristique de l'invention, la troisième portion de la couche d'espacement comporte des bords latéraux recouverts d'un matériau réfléchissant dans le domaine visible.

Ainsi, un avantage procuré est de réduire significativement les effets de diaphonie entre les sous-pixels rouge, vert et bleu grâce aux bords latéraux réfléchissants des première, deuxième et troisième portions de la couche d'espacement qui améliorent le confinement des rayons lumineux réfléchis dans la cavité optique.

Selon une caractéristique de l'invention, l'épaisseur de la troisième portion de la couche d'espacement est nulle, et le résonateur optique présente une épaisseur adaptée pour autoriser la transmission d'une lumière bleue issue de la lumière blanche émise par l'empilement.

Ainsi, un avantage procuré est de simplifier la fabrication du sous-pixel bleu en s'affranchissant du contrôle de l'épaisseur de la troisième portion de la couche d'espacement.

Selon une caractéristique de l'invention, le substrat comporte une couche diélectrique structurée, de préférence réalisée en SiO₂ ou en SiN, sur laquelle est formé le réflecteur ; la couche diélectrique structurée comprenant des premier, deuxième et troisième motifs associés respectivement aux sous-pixels rouge, vert et bleu ;
et les premier, deuxième et troisième motifs comportent chacun des bords latéraux recouverts d'un matériau électriquement conducteur, de préférence sélectionné parmi Al, Ag, Pt, Cr, Ni, W ; les bords latéraux des premier, deuxième et troisième motifs étant électriquement isolés entre eux.

Par « diélectrique », on entend que la couche présente une conductivité électrique à 300 K inférieure ou égale à 10⁻⁶ S/cm.

Par « électriquement conducteur », on entend que le matériau présente une conductivité électrique à 300 K supérieure ou égale à 10² S/cm.

Ainsi, un avantage procuré est la formation de trous d'interconnexion (« *vias* » en langue anglaise), dont les parois sont définies par deux bords latéraux appartenant à deux motifs adjacents, en regard l'un de l'autre. Les parois des trous d'interconnexion sont donc électriquement conductrices et l'intérieur des parois peut être rempli d'un matériau diélectrique. De tels trous d'interconnexion se distinguent de l'état de la technique où les parois sont diélectriques et l'intérieur des parois est électriquement conducteur.

Selon une caractéristique de l'invention, le matériau réfléchissant recouvrant les bords latéraux des première et deuxième portions de la couche d'espacement est électriquement conducteur ;
et les bords latéraux des premier et deuxième motifs de la couche diélectrique structurée s'étendent respectivement dans le prolongement des bords latéraux des première et deuxième portions de la couche d'espacement.

Ainsi, un avantage procuré est de connecter électriquement les trous d'interconnexion (formés par deux bords latéraux de deux motifs adjacents) à la première électrode par l'intermédiaire des bords latéraux des première et deuxième portions de la couche d'espacement. Une telle architecture permet d'accéder facilement, avec un encombrement réduit, à un circuit de commande des sous-pixels rouge et vert, intégré au substrat.

Selon une caractéristique de l'invention, le matériau réfléchissant recouvrant les bords latéraux des première, deuxième et troisième portions de la couche d'espacement est électriquement conducteur ;

et les bords latéraux des premier, deuxième et troisième motifs de la couche diélectrique structurée s'étendent respectivement dans le prolongement des bords latéraux des première, deuxième et troisième portions de la couche d'espacement.

Ainsi, un avantage procuré est de connecter électriquement les trous d'interconnexion (formés par deux bords latéraux de deux motifs adjacents) à la première électrode par l'intermédiaire des bords latéraux des première, deuxième et troisième portions de la couche d'espacement. Une telle architecture permet d'accéder facilement, et de manière compacte, à un circuit de commande des sous-pixels rouge, vert et bleu, intégré au substrat.

Selon une caractéristique de l'invention, le substrat comporte un circuit CMOS ;
et les bords latéraux des premier, deuxième et troisième motifs de la couche diélectrique structurée sont reliés électriquement au circuit CMOS.

Ainsi, un avantage procuré est d'accéder facilement, avec un encombrement réduit, au circuit de commande CMOS des sous-pixels rouge, vert, et bleu intégré au substrat.

Selon une caractéristique de l'invention, le réflecteur est réalisé dans un matériau sélectionné parmi Al, Ag, Pt, Cr, Ni, W.

Ainsi, de tels matériaux métalliques possèdent à la fois un coefficient de réflexion en intensité élevée dans le domaine visible, et une conductivité électrique élevée.

Selon une caractéristique de l'invention, le matériau réfléchissant recouvrant les bords latéraux des première, deuxième et troisième portions de la couche d'espacement est sélectionné parmi Al, Ag, Pt, Cr, Ni, W.

Ainsi, de tels matériaux métalliques possèdent à la fois un coefficient de réflexion en intensité élevée dans le domaine visible, et une conductivité électrique élevée.

Selon une caractéristique de l'invention, la couche d'espacement est réalisée dans un matériau électriquement conducteur et transparent dans le domaine visible, de préférence un oxyde, plus préférentiellement sélectionné parmi l'oxyde d'indium-étain, l'oxyde d'étain SnO₂, l'oxyde de zinc ZnO.

Selon une caractéristique de l'invention, les première, deuxième et troisième portions de la couche d'espacement comportent des bords latéraux électriquement isolés entre eux.

Selon une caractéristique de l'invention, la première électrode est réalisée en oxyde d'indium-étain.

Selon une caractéristique de l'invention, la deuxième électrode est réalisée dans un matériau sélectionné parmi Al, Ag, Pt, Cr, Ni, W.

Selon une caractéristique de l'invention, le substrat est réalisé dans un matériau semi-conducteur, de préférence le silicium.

L'invention a également pour objet un micro-écran à diodes électroluminescentes organiques, comportant une matrice de pixels conformes à l'invention.

L'invention a également pour objet un procédé de fabrication d'un pixel d'un micro-écran à diodes électroluminescentes organiques, comportant les étapes :
a) prévoir un substrat ;
b) former un réflecteur, réfléchissant dans le domaine visible, sur le substrat ;
c) former une couche d'espacement sur le réflecteur ;
d) former une première électrode, transparente dans le domaine visible, sur la couche d'espacement ;
e) former un empilement de couches électroluminescentes organiques sur la première électrode, l'empilement étant configuré pour émettre une lumière blanche ;
f) former une seconde électrode, semi-transparente dans le domaine visible, sur l'empilement ; la seconde électrode et le réflecteur formant un résonateur optique ;
l'étape c) étant exécutée de sorte que la couche d'espacement possède des première, deuxième, et troisième portions présentant des épaisseurs adaptées de sorte que le résonateur optique autorise respectivement la transmission de lumières rouge, verte et bleue issues de la lumière blanche émise par l'empilement, de manière à définir respectivement des sous-pixels rouge, vert et bleu ; les première et deuxième portions de la couche d'espacement présentant des bords latéraux ;
remarquable en ce que l'étape c) comporte une étape consistant à recouvrir, d'un matériau réfléchissant dans le domaine visible, les bords latéraux des première et deuxième portions de la couche d'espacement.

### Brève description des dessins

D'autres caractéristiques et avantages apparaîtront dans l'exposé détaillé de différents modes de réalisation de l'invention, l'exposé étant assorti d'exemples et de références aux dessins joints.
Figure 1 est une vue schématique en coupe d'un pixel selon l'invention, illustrant un premier mode de réalisation de la couche d'espacement, la coupe étant effectuée suivant la normale à la surface du pixel.
Figure 2 est une vue schématique en coupe d'un pixel selon l'invention, illustrant un deuxième mode de réalisation de la couche d'espacement, la coupe étant effectuée suivant la normale à la surface du pixel.
Figures 3a à 3k sont des vues schématiques en coupe selon la normale au substrat, illustrant des étapes d'un premier procédé de fabrication selon l'invention.
Figures 4a à 4k sont des vues schématiques en coupe selon la normale au substrat, illustrant des étapes d'un deuxième procédé de fabrication selon l'invention.
Figures 5a à 5k sont des vues schématiques en coupe selon la normale au substrat, illustrant des étapes d'un troisième procédé de fabrication selon l'invention.
Figures 6a à 6h sont des vues schématiques en coupe selon la normale au substrat, illustrant des étapes d'un quatrième procédé de fabrication selon l'invention.

Il est à noter que les dessins décrits ci-avant sont schématiques et ne sont pas à l'échelle par souci de lisibilité et pour simplifier leur compréhension.

### Exposé détaillé des modes de réalisation

Les éléments identiques ou assurant la même fonction porteront les mêmes références pour les différents modes de réalisation, par souci de simplification.

Un objet de l'invention est un pixel d'un micro-écran à diodes électroluminescentes organiques, comportant successivement :
- un substrat 1 ;
- un réflecteur 2, réfléchissant dans le domaine visible, et formé sur le substrat 1 ;
- une couche d'espacement 3, formée sur le réflecteur 2 ;
- une première électrode E₁, transparente dans le domaine visible, et formée sur la couche d'espacement 3 ;
- un empilement 4 de couches électroluminescentes organiques, configuré pour émettre une lumière blanche, et formé sur la première électrode E₁,
- une seconde électrode E₂, semi-transparente dans le domaine visible, et formée sur l'empilement 4 ; la seconde électrode E₂ et le réflecteur 2 formant un résonateur optique ;
la couche d'espacement 3 possédant des première, deuxième, et troisième portions 30, 31, 32 présentant des épaisseurs adaptées de sorte que le résonateur optique autorise respectivement la transmission de lumières rouge, verte et bleue issues de la lumière blanche émise par l'empilement 4, de manière à définir respectivement des sous-pixels rouge, vert et bleu PR, PV, PB.

Les première et deuxième portions 30, 31 de la couche d'espacement 3 comportent chacune des bords latéraux 300 recouverts d'un matériau réfléchissant dans le domaine visible.

### Couche d'espacement

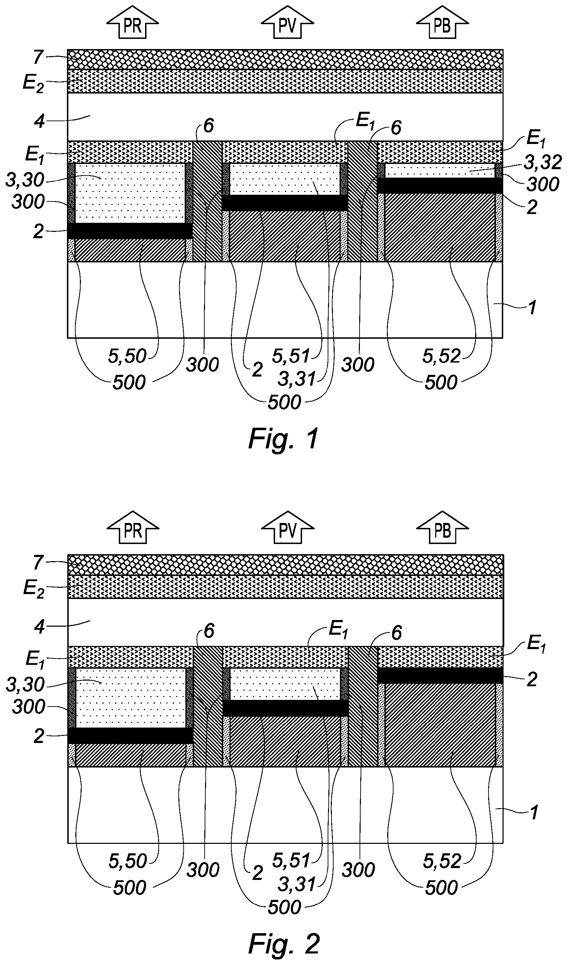

Comme illustré à la figure 1, la troisième portion 32 de la couche d'espacement 3 peut comporter des bords latéraux 300 recouverts d'un matériau réfléchissant dans le domaine visible. Le matériau réfléchissant recouvrant les bords latéraux 300 des première, deuxième et troisième portions 30, 31, 32 de la couche d'espacement 3 est avantageusement électriquement conducteur. Le matériau réfléchissant recouvrant les bords latéraux 300 des première, deuxième et troisième portions 30, 31, 32 de la couche d'espacement 3 est avantageusement sélectionné parmi Al, Ag, Pt, Cr, Ni, W. Le matériau réfléchissant recouvrant les bords latéraux 300 des première, deuxième et troisième portions 30, 31, 32 de la couche d'espacement 3 possède un coefficient de réflexion en intensité supérieur ou égal à 70%, de préférence supérieur ou égal à 80%, plus préférentiellement supérieur ou égal à 85%, encore plus préférentiellement supérieur ou égal à 90%, moyenné sur le domaine visible.

Selon une alternative illustrée à la figure 2, l'épaisseur de la troisième portion 32 de la couche d'espacement 3 est nulle, et le résonateur optique présente une épaisseur adaptée pour autoriser la transmission d'une lumière bleue issue de la lumière blanche émise par l'empilement 4.

La couche d'espacement 3 est avantageusement réalisée dans un matériau électriquement conducteur et transparent dans le domaine visible, de préférence un oxyde, plus préférentiellement sélectionné parmi l'oxyde d'indium-étain, l'oxyde d'étain SnO₂, l'oxyde de zinc ZnO.

### Substrat

Le substrat 1 est avantageusement réalisé dans un matériau semi-conducteur, de préférence le silicium.

Le substrat 1 comporte avantageusement une couche diélectrique 5 structurée, de préférence réalisée en SiO₂ ou en SiN, sur laquelle est formé le réflecteur 2. La couche diélectrique 5 structurée comprend des premier, deuxième et troisième motifs 50, 51, 52 associés respectivement aux sous-pixels rouge, vert et bleu PR, PV, PB. Les premier, deuxième et troisième motifs 50, 51, 52 sont séparés entre eux d'une distance correspondant à la distance souhaitée entre les sous-pixels, par exemple de l'ordre de 600 nm. Les premier, deuxième et troisième motifs 50, 51, 52 de la couche diélectrique 5 structurée présentent avantageusement des épaisseurs adaptées aux épaisseurs des première, deuxième et troisième portions 30, 31, 32 de la couche d'espacement 3 de manière à obtenir une première électrode E₁ plane.

Les premier, deuxième et troisième motifs 50, 51, 52 comportent avantageusement chacun des bords latéraux 500 recouverts d'un matériau électriquement conducteur, de préférence sélectionné parmi Al, Ag, Pt, Cr, Ni, W. Le cas échéant, les bords latéraux 500 des premier, deuxième et troisième motifs 50, 51, 52 sont électriquement isolés entre eux, de préférence par l'intermédiaire d'une couche diélectrique intercalaire 6, par exemple réalisée en SiO₂ ou en SiN. La couche diélectrique intercalaire 6 s'étend avantageusement jusqu'à affleurer la surface de la première électrode E₁. Ainsi, les bords latéraux 300 des première, deuxième et troisième portions 30, 31, 32 de la couche d'espacement 3 sont électriquement isolés entre eux par la couche diélectrique intercalaire 6.

Les bords latéraux 500 des premier et deuxième motifs 50, 51 de la couche diélectrique 5 structurée s'étendent avantageusement respectivement dans le prolongement des bords latéraux 300 des première et deuxième portions 30, 31 de la couche d'espacement 3. Lorsque la troisième portion 32 de la couche d'espacement 3 comporte des bords latéraux 300 recouverts d'un matériau réfléchissant dans le domaine visible, les bords latéraux 500 du troisième motif 52 de la couche diélectrique 5 structurée s'étendent avantageusement dans le prolongement des bords latéraux 300 de la troisième portion 32 de la couche d'espacement 3.

Le substrat 1 peut comporter un circuit CMOS formant un circuit de commande des sous-pixels rouge, vert et bleu PR, PV, PB. Les bords latéraux 500 des premier, deuxième et troisième motifs 50, 51, 52 de la couche diélectrique 5 structurée sont avantageusement reliés électriquement au circuit CMOS.

### Réflecteur

Le réflecteur 2 est réalisé dans un matériau, de préférence métallique, plus préférentiellement sélectionné parmi Al, Ag, Pt, Cr, Ni, W. Le matériau dans lequel est réalisé le réflecteur 2 est avantageusement identique au matériau réfléchissant recouvrant les bords latéraux 300 des première, deuxième et troisième portions 30, 31, 32 de la couche d'espacement 3 afin de simplifier le procédé de fabrication. De la même façon, le matériau dans lequel est réalisé le réflecteur 2 est avantageusement identique au matériau électriquement conducteur recouvrant les bords latéraux 500 des premier, deuxième et troisième motifs 50, 51, 52 de la couche diélectrique 5 structurée afin de simplifier le procédé de fabrication.

Le réflecteur 2 présente préférentiellement une épaisseur comprise entre 0,1 µm et 2 µm.

Le réflecteur 2 possède un coefficient de réflexion en intensité supérieur ou égal à 70%, de préférence supérieur ou égal à 80%, plus préférentiellement supérieur ou égal à 85%, encore plus préférentiellement supérieur ou égal à 90%, moyenné sur le domaine visible.

### Première et seconde électrodes

Les première et seconde électrodes E₁, E₂ de chaque sous-pixel rouge, vert, bleu PR, PV, PB présentent une épaisseur constante.

La première électrode E₁ de chaque sous-pixel rouge, vert, bleu PR, PV, PB est avantageusement réalisée en oxyde d'indium-étain. La première électrode E₁ de chaque sous-pixel rouge, vert, bleu PR, PV, PB possède un coefficient de transmission en intensité supérieur ou égal à 70%, de préférence supérieur ou égal à 80%, plus préférentiellement supérieur ou égal à 85%, encore plus préférentiellement supérieur ou égal à 90%, moyenné sur le domaine visible.

La seconde électrode E₂ de chaque sous-pixel rouge, vert, bleu PR, PV, PB est avantageusement réalisée dans un matériau métallique, de préférence sélectionné parmi Al, Ag, Pt, Cr, Ni, W. La seconde électrode E₂ de chaque sous-pixel rouge, vert, bleu PR, PV, PB possède un coefficient de transmission en intensité strictement inférieur à 80%, de préférence strictement inférieur à 70%, plus préférentiellement strictement inférieur à 60%, moyenné sur le domaine visible. A titre d'exemple non limitatif, la seconde électrode E₂ de chaque sous-pixel rouge, vert, bleu PR, PV, PB peut être réalisée en Al avec une épaisseur comprise entre 10 nm et 20 nm.

La première électrode E₁ est préférentiellement une anode et la seconde électrode E₂ est préférentiellement une cathode.

La seconde électrode E₂ est avantageusement revêtue d'une couche d'encapsulation 7 adaptée pour protéger de l'air et de l'humidité la seconde électrode E₂ et l'empilement 4 de chaque sous-pixel rouge, vert et bleu PR, PV, PB.

### Empilement de couches électroluminescente organiques

L'empilement 4 de couches électroluminescentes organiques présente une épaisseur constante pour chaque sous-pixel rouge, vert et bleu PR, PV, PB.

A titre d'exemple non limitatif, l'empilement 4 peut comporter trois couches émissives en tandem. Plus précisément, lorsque la première électrode E₁ est une anode et la seconde électrode E₂ est une cathode, l'empilement 4 peut comporter :
- une première couche de transport de trous formée sur la première électrode E₁ ;
- une première couche émissive émettant une lumière bleue, formée sur la première couche de transport de trous ;
- une première couche de transport d'électrons, formée sur la première couche émissive ;
- une couche de génération de charges (appelée également couche d'interconnexion), formée sur la première couche de transport d'électrons ;
- une seconde couche de transport de trous, formée sur la couche de génération de charges ;
- une deuxième couche émissive émettant une lumière verte, formée sur la seconde couche de transport de trous ;
- une troisième couche émissive émettant une lumière rouge, formée sur la deuxième couche émissive ;
- une seconde couche de transport d'électrons, formée sur la troisième couche émissive, et destinée à être revêtue de la seconde électrode E₂.

A titre de variantes, l'empilement 4 peut comporter :
- trois couches émissives émettant respectivement des lumières bleue, verte et rouge sans être agencées en tandem (structure conventionnelle) ;
- deux couches émissives émettant respectivement des lumières jaune et bleue agencées en structure conventionnelle ;
- deux couches émissives émettant respectivement des lumières jaune et bleue agencées en structure tandem.

### Micro-écran

Un objet de l'invention est un micro-écran à diodes électroluminescentes organiques, comportant une matrice de pixels conformes à l'invention. Les pixels de la matrice présentent préférentiellement un pas compris entre 4 µm et 5 µm.

### Procédé de fabrication du pixel

Un objet de l'invention est un procédé de fabrication d'un pixel d'un micro-écran à diodes électroluminescentes organiques, comportant les étapes :
a) prévoir un substrat 1 ;
b) former un réflecteur 2, réfléchissant dans le domaine visible, sur le substrat 1 ;
c) former une couche d'espacement 3 sur le réflecteur 2 ;
d) former une première électrode E₁, transparente dans le domaine visible, sur la couche d'espacement 3 ;
e) former un empilement 4 de couches électroluminescentes organiques sur la première électrode E₁, l'empilement 4 étant configuré pour émettre une lumière blanche ;
f) former une seconde électrode E₂, semi-transparente dans le domaine visible, sur l'empilement 4 ; la seconde électrode E₂ et le réflecteur 2 formant un résonateur optique.

L'étape c) est exécutée de sorte que la couche d'espacement 3 possède des première, deuxième, et troisième portions 30, 31, 32 présentant des épaisseurs adaptées de sorte que le résonateur optique autorise respectivement la transmission de lumières rouge, verte et bleue issues de la lumière blanche émise par l'empilement 4, de manière à définir respectivement des sous-pixels rouge, vert et bleu PR, PV, PB ; les première et deuxième portions 30, 31 de la couche d'espacement 3 présentant des bords latéraux 300.

L'étape c) comporte une étape consistant à recouvrir, d'un matériau réfléchissant dans le domaine visible, les bords latéraux 300 des première et deuxième portions 30, 31 de la couche d'espacement 3.

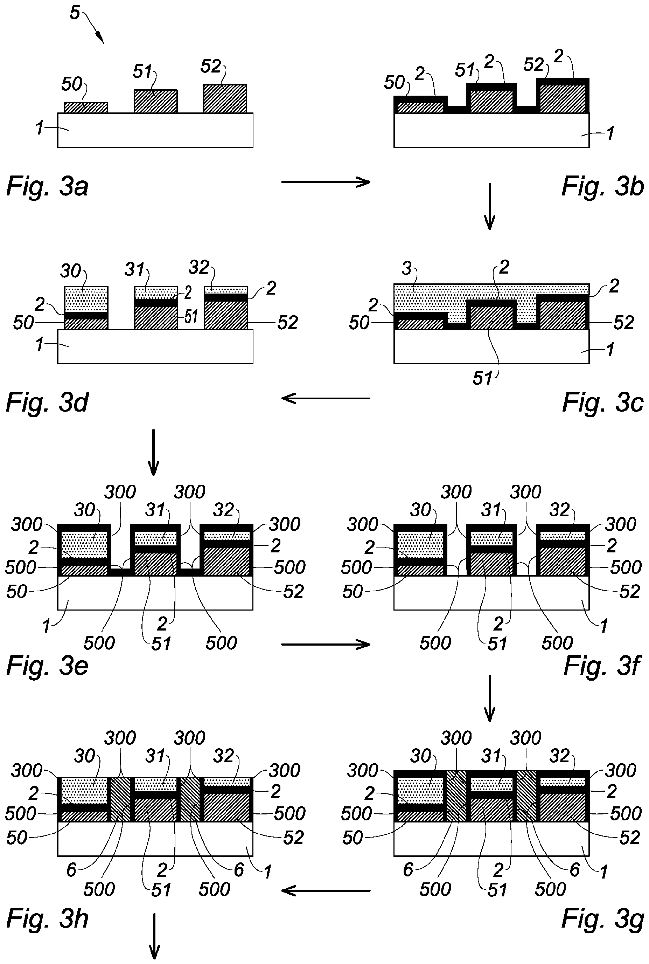

### Premier mode de mise en œuvre (figures 3a à 3k)

Comme illustré à la figure 3a, l'étape a) peut être exécutée par trois dépôts successifs de SiO₂ sur le substrat 1, formant les premier, deuxième et troisième motifs 50, 51, 52 de la couche diélectrique 5 structurée.

Comme illustré à la figure 3b, l'étape b) comporte un dépôt du matériau du réflecteur 2, par exemple Al avec une épaisseur de 100 nm. Le dépôt peut être exécuté par un dépôt physique en phase vapeur.

Comme illustré à la figure 3c, l'étape c) comporte un dépôt pleine plaque du matériau de la couche d'espacement 3 et une étape d'aplanissement, de préférence exécutée par polissage mécano-chimique.

Comme illustré à la figure 3d, les étapes b) et c) sont finalisées par lithogravure de manière à graver les matériaux du réflecteur 2 et de la couche d'espacement 3 et délimiter les sous-pixels rouge, vert et bleu PR, PV, PB.

Comme illustré à la figure 3e, l'étape c) comporte une étape c₁) consistant à recouvrir, d'un matériau réfléchissant dans le domaine visible, les bords latéraux 300 des première, deuxième et troisième portions 30, 31, 32 de la couche d'espacement 3. L'étape c₁) peut être exécutée par un dépôt du matériau réfléchissant, par exemple Al avec une épaisseur de 100 nm. L'étape c₁) conduit également à recouvrir du matériau réfléchissant les bords latéraux 500 des premier, deuxième et troisième motifs 50, 51, 52 de la couche diélectrique 5 structurée, le matériau réfléchissant étant choisi pour être également électriquement conducteur.

Comme illustrée aux figure 3f et 3g, l'étape c₁) est suivie d'une gravure du fond des tranchées puis d'un remplissage des tranchées d'une couche diélectrique intercalaire 6, par exemple réalisée en SiO₂ ou en SiN.

Comme illustrée à la figure 3h, le procédé comporte une étape d'aplanissement, de préférence exécutée par polissage mécano-chimique, de manière à rendre libre la surface de la couche d'espacement 3.

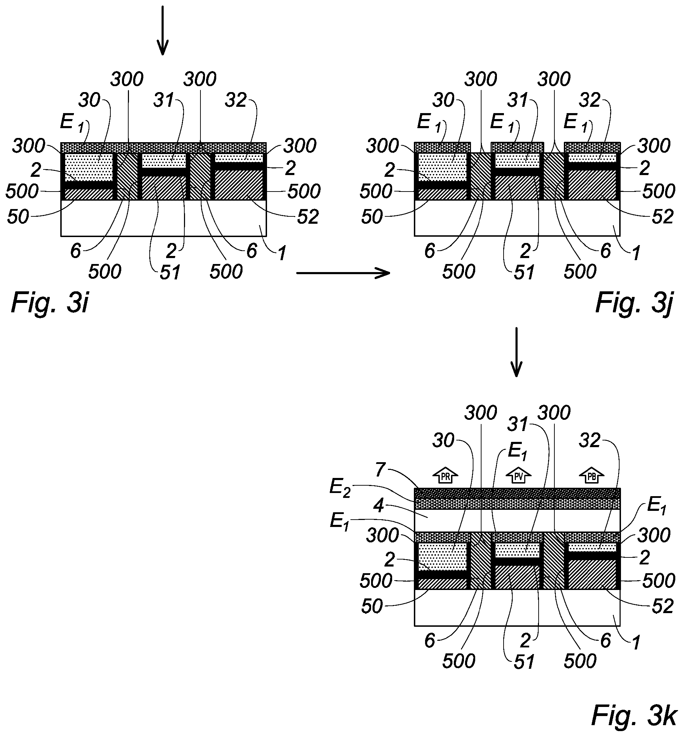

Comme illustré aux figures 3i et 3j, l'étape d) comporte un dépôt pleine plaque de la première électrode E₁, suivi d'une lithogravure adaptée pour délimiter les sous-pixels rouge, vert et bleu PR, PV, PB.

Comme illustré à la figure 3k, les étapes e) et f) sont exécutées par des techniques de dépôt connues de l'homme du métier. Le procédé peut comporter également une étape consistant à former une couche d'encapsulation 7 sur la seconde électrode E₂. Le procédé peut comporter également une étape consistant à étendre la couche diélectrique intercalaire 6 jusqu'à affleurer la surface de la première électrode E₁.

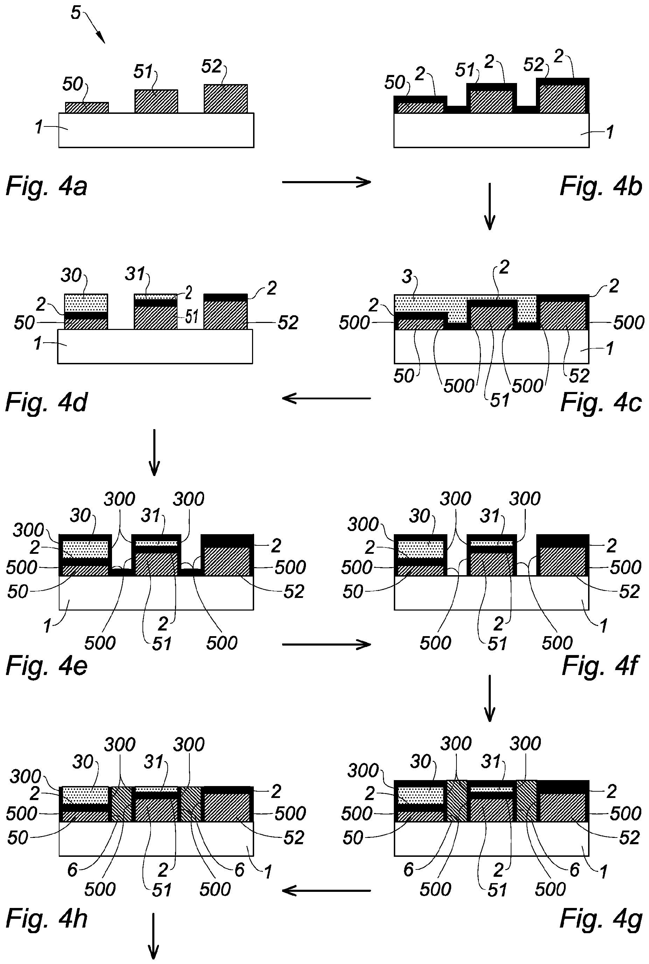

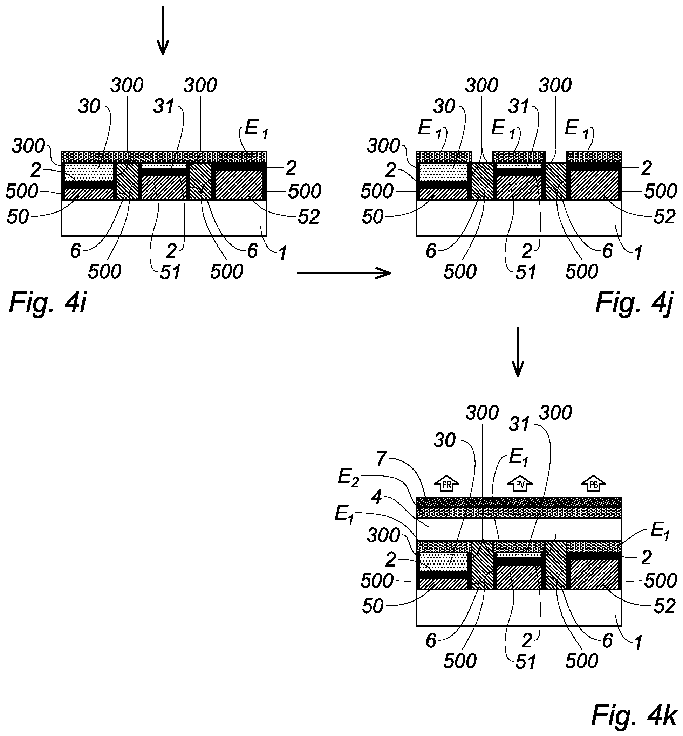

### Deuxième mode de mise en œuvre (figures 4a à 4k)

Comme illustré à la figure 4c, le deuxième mode de mise en œuvre diffère du premier mode de mise en œuvre en ce que l'étape d'aplanissement, de préférence un polissage mécano-chimique, de l'étape c) s'arrête sur le matériau du réflecteur 2 s'étendant sur le troisième motif 52 de la couche diélectrique 5 structurée. Ainsi, l'épaisseur de la troisième portion 32 de la couche d'espacement 3 est nulle, et les épaisseurs des première et deuxième portions 30, 31 de la couche d'espacement 3 sont parfaitement contrôlées.

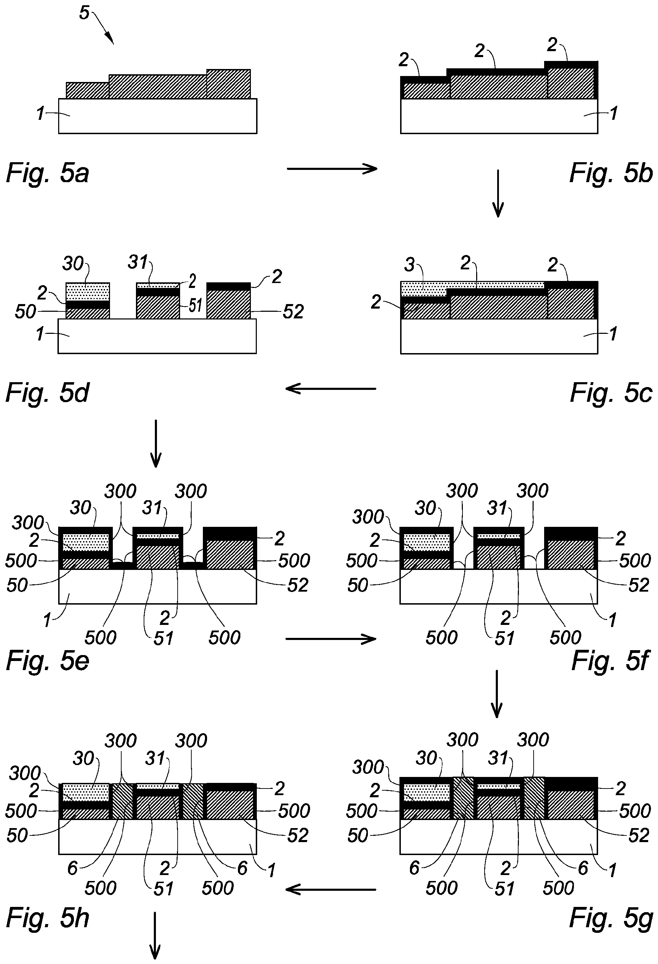

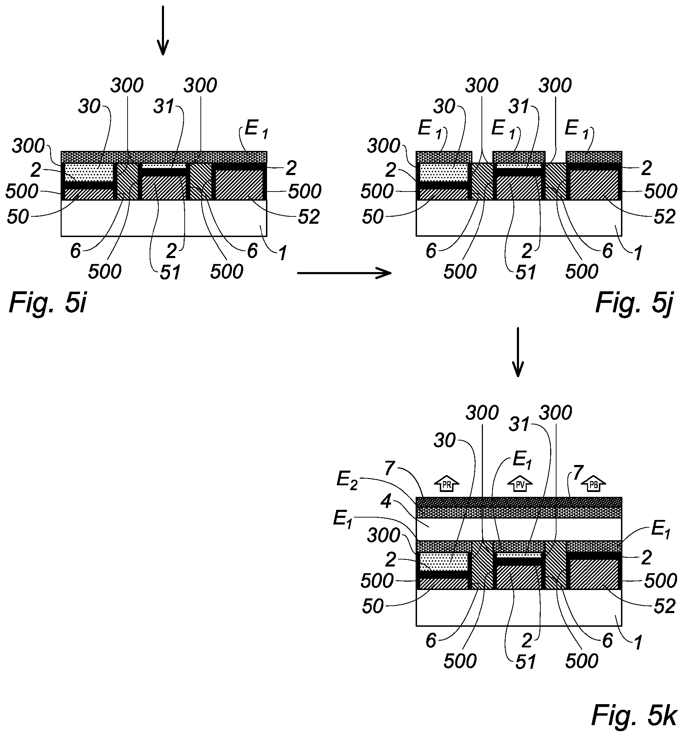

### Troisième mode de mise en œuvre (figures 5a à 5k)

Comme illustré à la figure 5a, le troisième mode de mise en œuvre diffère du deuxième mode de mise en œuvre en ce que la couche diélectrique structurée 5 est déposée en formant des marches continues.

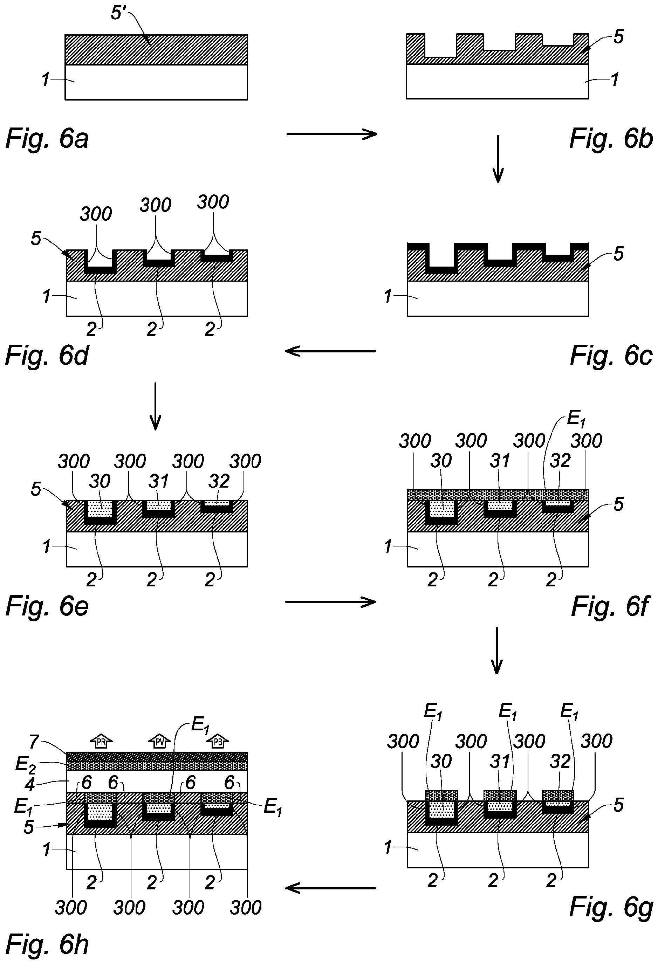

### Quatrième mode de mise en œuvre (figures 6a à 6h)

Comme illustré aux figures 6a et 6b, l'étape a) peut être exécutée par un dépôt pleine plaque d'une couche diélectrique 5' (par exemple en SiO₂ et d'une épaisseur de 150 nm) sur le substrat 1, suivi d'une structuration de la couche diélectrique 5' (par lithogravure) de manière à obtenir une couche diélectrique 5 structurée et délimiter les sous-pixel rouge, vert et bleu PR, PV, PB.

Comme illustré à la figure 6c, l'étape b) comporte un dépôt du matériau du réflecteur 2, par exemple Al avec une épaisseur de 100 nm, sur la couche diélectrique 5 structurée. Le dépôt peut être exécuté par un dépôt physique en phase vapeur.

Comme illustré à la figure 6d, le matériau du réflecteur 2 superficiel est ôté par exemple par polissage mécano-chimique.

Comme illustré à la figure 6e, l'étape c) comporte :
- un dépôt du matériau de la couche d'espacement 3 sur le matériau du réflecteur 2 de sorte que les bords latéraux 300 des première, deuxième et troisième portions 30, 31, 32 de la couche d'espacement 3 sont recouverts du matériau du réflecteur 2,
- un aplanissement de la couche d'espacement 3, de préférence par polissage mécano-chimique.

Comme illustré aux figures 6f et 6g, l'étape d) comporte un dépôt pleine plaque de la première électrode E₁, suivi d'une lithogravure adaptée pour délimiter les sous-pixels rouge, vert et bleu PR, PV, PB.

Comme illustré à la figure 6h, les étapes e) et f) sont exécutées par des techniques de dépôt connues de l'homme du métier. Le procédé peut comporter également une étape consistant à former une couche d'encapsulation 7 sur la seconde électrode E₂. Le procédé peut comporter également une étape consistant à former une couche diélectrique intercalaire 6 sur la couche diélectrique 5 structurée jusqu'à affleurer la surface de la première électrode E₁.

## Revendications

1. Pixel d'un micro-écran à diodes électroluminescentes organiques, comportant successivement :
- un substrat (1) ;
- un réflecteur (2), réfléchissant dans le domaine visible, et formé sur le substrat (1) ;
- une couche d'espacement (3), formée sur le réflecteur (2) ;
- une première électrode (E₁), transparente dans le domaine visible, et formée sur la couche d'espacement (3) ;
- un empilement (4) de couches électroluminescentes organiques, configuré pour émettre une lumière blanche, et formé sur la première électrode (E₁),
- une seconde électrode (E₂), semi-transparente dans le domaine visible, et formée sur l'empilement (4) ; la seconde électrode (E₂) et le réflecteur (2) formant un résonateur optique ;
la couche d'espacement (3) possédant des première, deuxième, et troisième portions (30, 31, 32) présentant des épaisseurs adaptées de sorte que le résonateur optique autorise respectivement la transmission de lumières rouge, verte et bleue issues de la lumière blanche émise par l'empilement (4), de manière à définir respectivement des sous-pixels rouge, vert et bleu (PR, PV, PB) ;
**caractérisé en ce que** les première et deuxième portions (30, 31) de la couche d'espacement (3) comportent chacune des bords latéraux (300) recouverts d'un matériau réfléchissant dans le domaine visible.

2. Pixel selon la revendication 1, dans lequel la troisième portion (32) de la couche d'espacement (3) comporte des bords latéraux (300) recouverts d'un matériau réfléchissant dans le domaine visible.

3. Pixel d'un micro-écran à diodes électroluminescentes organiques, comportant successivement :
- un substrat (1) ;
- un réflecteur (2), réfléchissant dans le domaine visible, et formé sur le substrat (1) ;
- une couche d'espacement (3), formée sur le réflecteur (2) ;
- une première électrode (E₁), transparente dans le domaine visible, et formée sur la couche d'espacement (3) ;
- un empilement (4) de couches électroluminescentes organiques, configuré pour émettre une lumière blanche, et formé sur la première électrode (E₁),
- une seconde électrode (E₂), semi-transparente dans le domaine visible, et formée sur l'empilement (4) ; la seconde électrode (E₂) et le réflecteur (2) formant un résonateur optique ;
le résonateur optique présentant une épaisseur adaptée pour autoriser la transmission d'une lumière bleue issue de la lumière blanche émise par l'empilement (4) de manière à définir un sous-pixel bleu (PB) ;
la couche d'espacement (3) possédant des première et deuxième portions (30, 31) présentant des épaisseurs adaptées de sorte que le résonateur optique autorise respectivement la transmission de lumières rouge et verte issues de la lumière blanche émise par l'empilement (4), de manière à définir respectivement des sous-pixels rouge et vert (PR, PV) ;
**caractérisé en ce que** les première et deuxième portions (30, 31) de la couche d'espacement (3) comportent chacune des bords latéraux (300) recouverts d'un matériau réfléchissant dans le domaine visible.

4. Pixel selon l'une des revendications 1 à 3, dans lequel le substrat (1) comporte une couche diélectrique (5) structurée, de préférence réalisée en SiO₂ ou en SiN, sur laquelle est formé le réflecteur (2) ; la couche diélectrique (5) structurée comprenant des premier, deuxième et troisième motifs (50, 51, 52) associés respectivement aux sous-pixels rouge, vert et bleu (PR, PV, PB) ;
et dans lequel les premier, deuxième et troisième motifs (50, 51, 52) comportent chacun des bords latéraux (500) recouverts d'un matériau électriquement conducteur, de préférence sélectionné parmi Al, Ag, Pt, Cr, Ni, W ; les bords latéraux (500) des premier, deuxième et troisième motifs (50, 51, 52) étant électriquement isolés entre eux.

5. Pixel selon la revendication 4 en combinaison avec la revendication 1 ou 3, dans lequel le matériau réfléchissant recouvrant les bords latéraux (300) des première et deuxième portions (30, 31) de la couche d'espacement (3) est électriquement conducteur ;
et dans lequel les bords latéraux (500) des premier et deuxième motifs (50, 51) de la couche diélectrique (5) structurée s'étendent respectivement dans le prolongement des bords latéraux (300) des première et deuxième portions (30, 31) de la couche d'espacement (3).

6. Pixel selon la revendication 4 en combinaison avec la revendication 2, dans lequel le matériau réfléchissant recouvrant les bords latéraux (300) des première, deuxième et troisième portions (30, 31, 32) de la couche d'espacement (3) est électriquement conducteur ;
et dans lequel les bords latéraux (500) des premier, deuxième et troisième motifs (50, 51, 52) de la couche diélectrique (5) structurée s'étendent respectivement dans le prolongement des bords latéraux (300) des première, deuxième et troisième portions (30, 31, 32) de la couche d'espacement (3).

7. Pixel selon la revendication 5 ou 6, dans lequel le substrat (1) comporte un circuit CMOS;
et dans lequel les bords latéraux (500) des premier, deuxième et troisième motifs (50, 51, 52) de la couche diélectrique (5) structurée sont reliés électriquement au circuit CMOS.

8. Pixel selon l'une des revendications 1 à 7, dans lequel le réflecteur (2) est réalisé dans un matériau sélectionné parmi Al, Ag, Pt, Cr, Ni, W.

9. Pixel selon la revendication 3 ou l'une des revendications 4 à 8 en combinaison avec la revendication 3, dans lequel le matériau réfléchissant recouvrant les bords latéraux (300) des première et deuxième portions (30, 31) de la couche d'espacement (3) est sélectionné parmi Al, Ag, Pt, Cr, Ni, W.

10. Pixel selon la revendication 1 ou 2 ou l'une des revendications 4 à 8 en combinaison avec la revendication 1 ou 2, dans lequel le matériau réfléchissant recouvrant les bords latéraux (300) des première, deuxième et troisième portions (32) de la couche d'espacement (3) est sélectionné parmi Al, Ag, Pt, Cr, Ni, W.

11. Pixel selon l'une des revendications 1 à 10, dans lequel la couche d'espacement (3) est réalisée dans un matériau électriquement conducteur et transparent dans le domaine visible, de préférence un oxyde, plus préférentiellement sélectionné parmi l'oxyde d'indium-étain, l'oxyde d'étain SnO₂, l'oxyde de zinc ZnO.

12. Pixel selon la revendication 3 ou l'une des revendications 4 à 9 et 11 en combinaison avec la revendication 3, dans lequel les première et deuxième portions (30, 31) de la couche d'espacement (3) comportent des bords latéraux (300) électriquement isolés entre eux.

13. Pixel selon la revendication 1 ou 2 ou l'une des revendications 4 à 8, 10 et 11 en combinaison avec la revendication 1 ou 2, dans lequel les première, deuxième et troisième portions (30, 31, 32) de la couche d'espacement (3) comportent des bords latéraux (300) électriquement isolés entre eux.

14. Micro-écran à diodes électroluminescentes organiques, comportant une matrice de pixels selon l'une des revendications 1 à 13.

15. Procédé de fabrication d'un pixel d'un micro-écran à diodes électroluminescentes organiques, comportant les étapes :
a) prévoir un substrat (1) ;
b) former un réflecteur (2), réfléchissant dans le domaine visible, sur le substrat (1) ;
c) former une couche d'espacement (3) sur le réflecteur (2) ;
d) former une première électrode (E₁), transparente dans le domaine visible, sur la couche d'espacement (3) ;
e) former un empilement (4) de couches électroluminescentes organiques sur la première électrode (E₁), l'empilement (4) étant configuré pour émettre une lumière blanche ;
f) former une seconde électrode (E₂), semi-transparente dans le domaine visible, sur l'empilement (4) ; la seconde électrode (E₂) et le réflecteur (2) formant un résonateur optique ;
l'étape c) étant exécutée de sorte que la couche d'espacement (3) possède des première, deuxième, et troisième portions (30, 31, 32) présentant des épaisseurs adaptées de sorte que le résonateur optique autorise respectivement la transmission de lumières rouge, verte et bleue issues de la lumière blanche émise par l'empilement (4), de manière à définir respectivement des sous-pixels rouge, vert et bleu (PR, PV, PB) ; les première et deuxième portions (30, 31) de la couche d'espacement (3) présentant des bords latéraux (300) ;
**caractérisé en ce que** l'étape c) comporte une étape consistant à recouvrir, d'un matériau réfléchissant dans le domaine visible, les bords latéraux (300) des première et deuxième portions (30, 31) de la couche d'espacement (3).

## Patentansprüche

1. Pixel eines Mikrobildschirms mit organischen Leuchtdioden, umfassend nacheinander:
- ein Substrat (1);
- einen Reflektor (2), der im sichtbaren Bereich reflektiert und auf dem Substrat (1) gebildet ist;
- eine Abstandsschicht (3), die auf dem Reflektor (2) gebildet ist;
- eine erste Elektrode (E₁), die im sichtbaren Bereich transparent ist und auf der Abstandsschicht (3) gebildet ist;
- einen Stapel (4) aus organischen elektrolumineszenten Schichten, der dazu ausgestaltet ist, ein weißes Licht zu emittieren, und auf der ersten Elektrode (E₁) gebildet ist,
- eine zweite Elektrode (E₂), die im sichtbaren Bereich halbtransparent ist und auf dem Stapel (4) gebildet ist, wobei die zweite Elektrode (E₂) und der Reflektor (2) einen optischen Resonator bilden;
- wobei die Abstandsschicht (3) erste, zweite und dritte Abschnitte (30, 31, 32) besitzt, die geeignete Dicken aufweisen, so dass der optische Resonator die Transmission von rotem, grünem beziehungsweise blauem Licht zulässt, das aus dem vom Stapel (4) emittierten weißen Licht stammt, so dass rote, grüne beziehungsweise blaue Subpixel (PR, PV, PB) definiert werden;
- **dadurch gekennzeichnet, dass** die ersten und zweiten Abschnitte (30, 31) der Abstandsschicht (3) jeweils seitliche Ränder (300) umfassen, die mit einem im sichtbaren Bereich reflektierenden Material überzogen sind.

2. Pixel nach Anspruch 1, bei dem der dritte Abschnitt (32) der Abstandsschicht (3) seitliche Ränder (300) umfasst, die mit einem im sichtbaren Bereich reflektierenden Material überzogen sind.

3. Pixel eines Mikrobildschirms mit organischen Leuchtdioden, umfassend nacheinander:
- ein Substrat (1);
- einen Reflektor (2), der im sichtbaren Bereich reflektiert und auf dem Substrat (1) gebildet ist;
- eine Abstandsschicht (3), die auf dem Reflektor (2) gebildet ist;
- eine erste Elektrode (E₁), die im sichtbaren Bereich transparent ist und auf der Abstandsschicht (3) gebildet ist;
- einen Stapel (4) aus organischen elektrolumineszenten Schichten, der dazu ausgestaltet ist, ein weißes Licht zu emittieren, und auf der ersten Elektrode (E₁) gebildet ist,
- eine zweite Elektrode (E₂), die im sichtbaren Bereich halbtransparent ist und auf dem Stapel (4) gebildet ist, wobei die zweite Elektrode (E₂) und der Reflektor (2) einen optischen Resonator bilden;
- wobei der optische Resonator eine geeignete Dicke aufweist, um die Transmission eines blauen Lichts zuzulassen, das aus dem vom Stapel (4) emittierten weißen Licht stammt, so dass ein blaues Subpixel (PB) definiert wird;
- wobei die Abstandsschicht (3) erste und zweite Abschnitte (30, 31) besitzt, die geeignete Dicken aufweisen, so dass der optische Resonator die Transmission von rotem und grünem Licht zulässt, das aus dem vom Stapel (4) emittierten weißen Licht stammt, so dass rote und grüne Subpixel (PR, PV) definiert werden;
- **dadurch gekennzeichnet, dass** die ersten und zweiten Abschnitte (30, 31) der Abstandsschicht (3) jeweils seitliche Ränder (300) umfassen, die mit einem im sichtbaren Bereich reflektierenden Material überzogen sind.

4. Pixel nach einem der Ansprüche 1 bis 3, bei dem das Substrat (1) eine strukturierte dielektrische Schicht (5) beinhaltet, die bevorzugt aus SiO₂ oder aus SiN ausgeführt ist, auf welcher der Reflektor (2) gebildet ist, wobei die strukturierte dielektrische Schicht (5) erste, zweite und dritte Muster (50, 51, 52) umfasst, die den roten, grünen beziehungsweise blauen Subpixeln (PR, PV, PB) zugeordnet sind;
und bei dem die ersten, zweiten und dritten Muster (50, 51, 52) jeweils seitliche Ränder (500) beinhalten, die mit einem elektrisch leitfähigen Material überzogen sind, das bevorzugt unter Al, Ag, Pt, Cr, Ni, W gewählt ist, wobei die seitlichen Ränder (500) der ersten, zweiten und dritten Muster (50, 51, 52) untereinander elektrisch isoliert sind.

5. Pixel nach Anspruch 4 in Kombination mit Anspruch 1 oder 3, bei dem das die seitlichen Ränder (300) der ersten und zweiten Abschnitte (30, 31) der Abstandsschicht (3) überziehende reflektierende Material elektrisch leitfähig ist;
und bei dem sich die seitlichen Ränder (500) der ersten und zweiten Muster (50, 51) der strukturierten dielektrischen Schicht (5) in der Verlängerung der seitlichen Ränder (300) der ersten beziehungsweise zweiten Abschnitte (30, 31) der Abstandsschicht (3) erstrecken.

6. Pixel nach Anspruch 4 in Kombination mit Anspruch 2, bei dem das die seitlichen Ränder (300) der ersten, zweiten und dritten Abschnitte (30, 31, 32) der Abstandsschicht (3) überziehende reflektierende Material elektrisch leitfähig ist;
und bei dem sich die seitlichen Ränder (500) der ersten, zweiten und dritten Muster (50, 51, 52) der strukturierten dielektrischen Schicht (5) in der Verlängerung der seitlichen Ränder (300) der ersten, zweiten beziehungsweise dritten Abschnitte (30, 31, 32) der Abstandsschicht (3) erstrecken.

7. Pixel nach Anspruch 5 oder 6, bei dem das Substrat (1) eine CMOS-Schaltung beinhaltet;
und bei dem die seitlichen Ränder (500) der ersten, zweiten und dritten Muster (50, 51, 52) der strukturierten dielektrischen Schicht (5) elektrisch mit der CMOS-Schaltung verbunden sind.

8. Pixel nach einem der Ansprüche 1 bis 7, bei dem der Reflektor (2) aus einem unter Al, Ag, Pt, Cr, Ni, W gewählten Material ausgeführt ist.

9. Pixel nach Anspruch 3 oder einem der Ansprüche 4 bis 8 in Kombination mit Anspruch 3, bei dem das die seitlichen Ränder (300) der ersten und zweiten Abschnitte (30, 31) der Abstandsschicht (3) überziehende reflektierende Material unter Al, Ag, Pt, Cr, Ni, W gewählt ist.

10. Pixel nach Anspruch 1 oder 2 oder einem der Ansprüche 4 bis 8 in Kombination mit Anspruch 1 oder 2, bei dem das die seitlichen Ränder (300) der ersten, zweiten und dritten Abschnitte (32) der Abstandsschicht (3) überziehende reflektierende Material unter Al, Ag, Pt, Cr, Ni, W gewählt ist.

11. Pixel nach einem der Ansprüche 1 bis 10, bei dem die Abstandsschicht (3) aus einem elektrisch leitfähigen und im sichtbaren Bereich transparenten Material, bevorzugt einem Oxid, noch bevorzugter einem unter Indium-Zinn-Oxid, Zinnoxid SnO₂, Zinkoxid ZnO ausgewählten ausgeführt ist.

12. Pixel nach Anspruch 3 oder einem der Ansprüche 4 bis 9 und 11 in Kombination mit Anspruch 3, bei dem die ersten und zweiten Abschnitte (30, 31) der Abstandsschicht (3) untereinander elektrisch isolierte seitliche Ränder (300) beinhalten.

13. Pixel nach Anspruch 1 oder 2 oder einem der Ansprüche 4 bis 8, 10 und 11 in Kombination mit Anspruch 1 oder 2, bei dem die ersten, zweiten und dritten Abschnitte (30, 31, 32) der Abstandsschicht (3) untereinander elektrisch isolierte seitliche Ränder (300) beinhalten.

14. Mikrobildschirm mit organischen Leuchtdioden, der eine Matrix aus Pixeln nach einem der Ansprüche 1 bis 13 beinhaltet.

15. Verfahren zur Herstellung eines Pixels eines Mikrobildschirms mit organischen Leuchtdioden, umfassend die folgenden Schritte:
a) Bereitstellen eines Substrats (1);
b) Bilden eines Reflektors (2), der im sichtbaren Bereich reflektiert, auf dem Substrat (1);
c) Bilden einer Abstandsschicht (3) auf dem Reflektor (2);
d) Bilden einer ersten Elektrode (E₁), die im sichtbaren Bereich transparent ist, auf der Abstandsschicht (3);
e) Bilden eines Stapels (4) aus organischen elektrolumineszenten Schichten auf der ersten Elektrode (E₁), wobei der Stapel (4) dazu ausgestaltet ist, ein weißes Licht zu emittieren;
f) Bilden einer zweiten Elektrode (E₂), die im sichtbaren Bereich halbtransparent ist, auf dem Stapel (4), wobei die zweite Elektrode (E₂) und der Reflektor (2) einen optischen Resonator bilden;
wobei Schritt c) so durchgeführt wird, dass die Abstandsschicht (3) erste, zweite und dritte Abschnitte (30, 31, 32) besitzt, die geeignete Dicken aufweisen, so dass der optische Resonator die Transmission von rotem, grünem beziehungsweise blauem Licht zulässt, das aus dem vom Stapel (4) emittierten weißen Licht stammt, so dass rote, grüne beziehungsweise blaue Subpixel (PR, PV, PB) definiert werden, wobei die ersten und zweiten Abschnitte (30, 31) der Abstandsschicht (3) seitliche Ränder (300) aufweisen;
**dadurch gekennzeichnet, dass** Schritt c) einen Schritt beinhaltet, der darin besteht, die seitlichen Ränder (300) der ersten und zweiten Abschnitte (30, 31) der Abstandsschicht (3) mit einem im sichtbaren Bereich reflektierenden Material zu überziehen.

## Claims

1. Pixel for an organic light-emitting diode microscreen, including, successively:
- a substrate (1);
- a reflector (2) that is reflective in the visible spectrum and is formed on the substrate (1);
- a spacing layer (3) that is formed on the reflector (2);
- a first electrode (E₁) that is transparent in the visible spectrum and is formed on the spacing layer (3);
- a stack (4) of organic light-emitting layers that is configured to emit a white light and is formed on the first electrode (E₁);
- a second electrode (E₂) that is semitransparent in the visible spectrum and is formed on the stack (4), the second electrode (E₂) and the reflector (2) forming an optical resonator;
the spacing layer (3) having first, second and third portions (30, 31, 32), the thicknesses of which are adjusted such that the optical resonator allows, respectively, the transmission of red, green and blue light from the white light emitted by the stack (4) so as to define, respectively, red, green and blue sub-pixels (PR, PV, PB);
**characterized in that** the first and second portions (30, 31) of the spacing layer (3) each include lateral edges (300) that are covered with a material that is reflective in the visible spectrum.

2. Pixel according to Claim 1, wherein the third portion (32) of the spacing layer (3) includes lateral edges (300) that are covered with a material that is reflective in the visible spectrum.

3. Pixel for an organic light-emitting diode microscreen, including, successively:
- a substrate (1);
- a reflector (2) that is reflective in the visible spectrum and is formed on the substrate (1);
- a spacing layer (3) that is formed on the reflector (2);
- a first electrode (E₁) that is transparent in the visible spectrum and is formed on the spacing layer (3);
- a stack (4) of organic light-emitting layers that is configured to emit a white light and is formed on the first electrode (E₁);
- a second electrode (E₂) that is semitransparent in the visible spectrum and is formed on the stack (4), the second electrode (E₂) and the reflector (2) forming an optical resonator; the optical resonator having a thickness which allows the transmission of blue light emitted by the stack (4) so as to define a blue sub-pixel (PB);
the spacing layer (3) having first and second portions (30, 31), the thicknesses of which are adjusted such that the optical resonator allows, respectively, the transmission of red and green light from the white light emitted by the stack (4) so as to define, respectively, red and green sub-pixels (PR, PV, PB);
**characterized in that** the first and second portions (30, 31) of the spacing layer (3) each include lateral edges (300) that are covered with a material that is reflective in the visible spectrum.

4. Pixel according to one of Claims 1 to 3, wherein the substrate (1) includes a structured dielectric layer (5), preferably made of SiO₂ or of SiN, on which the reflector (2) is formed, the structured dielectric layer (5) comprising first, second and third patterns (50, 51, 52) that are associated, respectively, with the red, green and blue sub-pixels (PR, PV, PB);
and wherein the first, second and third patterns (50, 51, 52) each include lateral edges (500) covered with an electrically conductive material, preferably selected from Al, Ag, Pt, Cr, Ni and W, the lateral edges (500) of the first, second and third patterns (50, 51, 52) being electrically insulated from one another.

5. Pixel according to Claim 4 in combination with Claim 1 or 3, wherein the reflective material covering the lateral edges (300) of the first and second portions (30, 31) of the spacing layer (3) is electrically conductive;
and wherein the lateral edges (500) of the first and second patterns (50, 51) of the structured dielectric layer (5) extend, respectively, in line with the lateral edges (300) of the first and second portions (30, 31) of the spacing layer (3).

6. Pixel according to Claim 4 in combination with Claim 2, wherein the reflective material covering the lateral edges (300) of the first, second and third portions (30, 31, 32) of the spacing layer (3) is electrically conductive;
and wherein the lateral edges (500) of the first, second and third patterns (50, 51, 52) of the structured dielectric layer (5) extend, respectively, in line with the lateral edges (300) of the first, second and third portions (30, 31, 32) of the spacing layer (3).

7. Pixel according to Claim 5 or 6, wherein the substrate (1) includes a CMOS circuit; and wherein the lateral edges (500) of the first, second and third patterns (50, 51, 52) of the structured dielectric layer (5) are electrically connected to the CMOS circuit.

8. Pixel according to one of Claims 1 to 7, wherein the reflector (2) is made of a material selected from Al, Ag, Pt, Cr, Ni and W.

9. Pixel according to Claim 3 or to one of Claims 4 to 8 in combination with Claim 3, wherein the reflective material covering the lateral edges (300) of the first and second portions (30, 31) of the spacing layer (3) is selected from Al, Ag, Pt, Cr, Ni and W.

10. Pixel according to Claim 1 or 2 or to one of Claims 4 to 8 in combination with Claim 1 or 2, wherein the reflective material covering the lateral edges (300) of the first, second and third portions (30, 31, 32) of the spacing layer (3) is selected from Al, Ag, Pt, Cr, Ni and W.

11. Pixel according to one of Claims 1 to 10, wherein the spacing layer (3) is made of a material that is electrically conductive and transparent in the visible spectrum, preferably an oxide, more preferably selected from indium tin oxide, tin oxide SnO₂ and zinc oxide ZnO.

12. Pixel according to Claim 3 or to one of Claims 4 to 9 in combination with Claim 3, wherein the first and second portions (30, 31) of the spacing layer (3) include lateral edges (300) that are electrically insulated from one another.

13. Pixel according to Claim 1 or 2 or to one of Claims 4 to 8, 10 and 11 in combination with Claim 1 or 2, wherein the first, second and third portions (30, 31, 32) of the spacing layer (3) include lateral edges (300) that are electrically insulated from one another.

14. Organic light-emitting diode microscreen including a matrix-array of pixels according to one of Claims 1 to 13.

15. Process for fabricating a pixel for an organic light-emitting diode microscreen, including the steps of:
a) providing a substrate (1);
b) forming a reflector (2) that is reflective in the visible spectrum on the substrate (1);
c) forming a spacing layer (3) on the reflector (2);
d) forming a first electrode (E₁) that is transparent in the visible spectrum on the spacing layer (3);
e) forming a stack (4) of organic light-emitting layers on the first electrode (E₁), the stack (4) being configured to emit a white light;
f) forming a second electrode (E₂) that is semitransparent in the visible spectrum on the stack (4), the second electrode (E₂) and the reflector (2) forming an optical resonator; step c) being carried out such that the spacing layer (3) has first, second and third portions (30, 31, 32), the thicknesses of which are adjusted such that the optical resonator allows, respectively, the transmission of red, green and blue light from the white light emitted by the stack (4) so as to define, respectively, red, green and blue sub-pixels (PR, PV, PB), the first and second portions (30, 31) of the spacing layer (3) having lateral edges (300);
**characterized in that** step c) includes a step of covering the lateral edges (300) of the first and second portions (30, 31) of the spacing layer (3) with a material that is reflective in the visible spectrum.
